(19) Europäisches Patentamt
European Patent Office
Office européen des brevets

(11) **EP 3 539 230 B1**

(12) **EUROPÄISCHE PATENTSCHRIFT**

(45) Veröffentlichungstag und Bekanntmachung des Hinweises auf die Patenterteilung:
**02.12.2020 Patentblatt 2020/49**

(21) Anmeldenummer: **17797515.8**

(22) Anmeldetag: **25.10.2017**

(51) Int Cl.:
**H04B 17/391** [(2015.01)]

(86) Internationale Anmeldenummer:
**PCT/AT2017/060286**

(87) Internationale Veröffentlichungsnummer:
**WO 2018/085869 (17.05.2018 Gazette 2018/20)**

(54) **VERFAHREN ZUR EMULATION EINES FUNKKANALS**

METHOD FOR EMULATING A RADIO CHANNEL

PROCÉDÉ D'ÉMULATION D'UN CANAL RADIO

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.11.2016 AT 510242016**

(43) Veröffentlichungstag der Anmeldung:
**18.09.2019 Patentblatt 2019/38**

(73) Patentinhaber: **AIT Austrian Institute of Technology GmbH**
**1210 Wien (AT)**

(72) Erfinder:
• **HOFER, Markus**
**3323 Neustadtl (AT)**
• **ZEMEN, Thomas**
**2345 Brunn am Gebirge (AT)**

(74) Vertreter: **Wildhack & Jellinek Patentanwälte**
**Landstraßer Hauptstraße 50**
**1030 Wien (AT)**

(56) Entgegenhaltungen:
**EP-A1- 1 578 032**

• **GHIAASI GOLSA ET AL: "Real-time vehicular channel emulator for future conformance tests of wireless ITS modems", 2016 10TH EUROPEAN CONFERENCE ON ANTENNAS AND PROPAGATION (EUCAP), EUROPEAN ASSOCIATION OF ANTENNAS AND PROPAGATION, 10. April 2016 (2016-04-10), Seiten 1-5, XP032906229, DOI: 10.1109/EUCAP.2016.7481226 [gefunden am 2016-05-31]**

**Beschreibung**

Die Erfindung betrifft ein Verfahren zur Emulation eines Funkkanals zwischen einem beweglichen Sender und einem beweglichen Empfänger, die jeweils an Antennen angeschlossen sind, in einem vorgebbaren den Funkkanal beeinflussenden Umfeld.

Aus dem Stand der Technik sind unterschiedliche Emulationsverfahren bekannt, mit denen das Verhalten eines Funkkanals emuliert werden kann. Die EP 1578032 A1  offenbart ein Verfahren und eine Vorrichtung zur Simulation von MxN Übertragungspfaden einer Multiantennen-Übertragungseinrichtung. GHIAASI GOLSA ET AL: "Real-time vehicular channel emulator for future conformance tests of wireless ITS modems", 2016 10TH EUROPEAN CONFERENCE ON ANTENNAS AND PROPAGATION (EUCAP), EUROPEAN ASSOCIATION OF ANTENNAS AND PROPAGATION, 10. April 2016, S1-5, XP032906229, zeigt eine Architektur für einen Echtzeit-Emulator zur Reproduktion des Input-/Output-Verhaltens eines nicht stationären, n-fachen Wireless-Übertragungskanals eines Fahrzeugs.

Aufgabe der Erfindung ist es, ein Verfahren bereitzustellen, das mit geringer Rechenzeit auskommt und damit in der Lage ist, ein Emulationsgebiet besonders genau abzubilden.

Die Erfindung löst diese Aufgabe bei einem Verfahren der eingangs genannten Art mit den Merkmalen des Patentanspruchs 1. Dabei ist vorgesehen ein Verfahren zur Emulation eines Funkkanals zwischen einem bewegten Sender und einem bewegten Empfänger, die jeweils an zumindest eine Antenne angeschlossen sind, in einem vorgebbaren den Funkkanal beeinflussenden Umfeld, wobei für eine Anzahl von hintereinander folgenden Zeitabschnitten

- jeweils die der Emulation zugrunde liegende Relativposition und Relativbewegung und gegebenenfalls relative Ausrichtung und Relativdrehung, der beiden Antennen zueinander vorgegeben wird, wobei die zeitliche Veränderung der Relativposition und Relativbewegung vorab vorgegeben ist, und insbesondere physikalischen Gesetzmäßigkeiten folgt,
- wobei anhand der Relativposition und Relativbewegung und gegebenenfalls relativen Ausrichtung und Relativdrehung sowie anhand des vorgegebenen Umfelds eine Anzahl von zwischen den Antennen verlaufenden Ausbreitungspfaden ermittelt wird, wobei für jeden der Ausbreitungspfade separat ein Dämpfungsfaktor, eine Verzögerung sowie eine Dopplerfrequenz ermittelt werden,
- wobei ausgehend von den einzelnen Ausbreitungspfaden für eine Anzahl hintereinander folgenden Zeitabschnitten jeweils

  - für jeden Ausbreitungspfad durch separaten Table-Lookup der Verzögerung und der Dopplerfrequenz, jeweils ein Koeffizientenvektor erstellt wird und mit diesen Koeffizientenvektoren durch Bildung des Kronecker-Produkts eine Pfadmatrix erstellt wird, und die so erstellten Pfadmatrizen der einzelnen Ausbreitungspfade mit der jeweiligen Dämpfung des Ausbreitungspfads gewichtet und summiert werden,
  - ausgehend von der so erstellten Summenmatrix mittels einer linearen Transformation eine Übertragungsmatrix ermittelt wird, wobei die Transformation diejenige, insbesondere ausschließlich diejenige, Dimension der Übertragungsmatrix gegenüber der Summenmatrix reduziert, die dem Koeffizientenvektor der Verzögerung entspricht, und
  - die Übertragungsmatrix an den programmierbaren Schaltkreis übertragen wird,
  - wobei im programmierbaren Schaltkreis eine Anzahl von diskreten, die Zeitvarianz der Übertragungsfunktionen und/oder der Impulsantwort charakterisierenden Basisfunktionen als Basismatrix, vorgegeben wird,
  - wobei die zeitveränderlichen Impulsantworten des jeweiligen Zeitabschnitts durch Multiplikation der Übertragungsmatrix mit der Basismatrix ermittelt werden,
  - wobei das von dem Sender erzeugte Signal an einem Eingang abgetastet und digitalisiert und derart ein diskretes Eingangssignal erstellt wird,
  - wobei das diskrete Eingangssignal mit einer zeitveränderlichen Impulsantwort von einem digitalen Schaltkreis gefaltet und derart ein diskretes Ausgangssignal erstellt wird, und
  - dass insbesondere ausgehend vom diskreten Ausgangssignal ein zeit- und wertkontinuierliches Ausgangssignal erstellt wird.

Um den Anstieg oder Abfall der Dämpfung während eines Zeitabschnitts besser beschreiben zu können und um in der Emulation entstehende Artefakte zu vermeiden, kann vorgesehen sein,

- dass für die einzelnen hintereinander folgenden Zeitabschnitte die Dämpfung für die einzelnen Ausbreitungspfade mit linearer Abhängigkeit von der diskreten Zeit vorgegeben wird, wobei als Pfadparameter für die Dämpfung ein konstanter Term und ein zeitabhängiger Term vorgegeben werden,
- wobei für jeden Zeitabschnitt und für jeden Ausbreitungspfad

- durch separaten Table-Lookup der Verzögerung ein Verzögerungsvektor und durch separaten Table-Lookup der Dopplerfrequenz ein Dopplervektor erstellt wird,
- ein aufgrund der Dopplerfrequenz ein weiterer Dopplervektor erstellt wird, wobei der weitere Dopplervektor insbesondere erstelt wird:

-- durch Table-Lookup in einem weiteren Lookup-Table, oder
-- durch Ermittlung aufgrund der folgenden Vorschrift,

$$\boldsymbol{\gamma}_p'' = \mathbf{U}^H \text{diag}(\mathbf{m}) \mathbf{U} \boldsymbol{\gamma}_p'$$

wobei die Matrix diag($\mathbf{m}$) eine Diagonalmatrix bezeichnet, in deren Diagonaleneinträgen die Einträge des Vektors $\mathbf{m}$ = [0,1,...,M-1] enthalten sind, die Matrix $\mathbf{U}$ die Matrix der Basisfunktionen und die Matrix $\mathbf{U}^H$ die konjugiert Transponierte der Matrix $\mathbf{U}$ bezeichnet,

- das Kronecker-Produkt des Verzögerungsvektors und des Dopplervektors gebildet und mit dem konstanten Term der Dämpfung gewichtet wird und,
- das Kronecker-Prdoukt des Verzögerungsvektors und des weiteren Dopplervektor gebildet und mit dem zeitabhängigen Term der Dämpfung geichtet wird, und
- die Pfadmatrix als Summe dieser Kronecker-Produkte errechnet wird.

Zur Vermeidung von Artefakten, die aufgrund von Phasensprüngen entstehen, kann vorgesehen sein,

- dass für die einzelnen Zeitabschnitte für jeden einzelnen Ausbreitungspfad jeweils eine zu Beginn des aktuellen Zeitabschnitts vorliegende initiale Phasenverschiebung zur Verfügung gehalten wird und jeweils nach dem Ende des Zeitabschnitts eine initiale Phasenverschiebung für den nachfolgenden Zeitabschnitt gemäß

$$\phi_{p,S} = \phi_{p,S-1} + v_{p,S-1} M$$

ermittelt wird,
wobei $v_{p,S-1}$ die Dopplerfrequenz im jeweils vorangehenden Zeitabschnitt bezeichnet und M die Länge der Zeitabschnitte festlegt, und
- dass bei der Bestimmung der Pfadmatrix für die einzelnen Ausbreitungspfade eine Phasenkorrektur entsprechend der jeweiligen initialen Phasenverschiebung vorgenommen wird, insbesondere durch Gewichtung oder Multiplikation mit $e^{j \Phi_{p,S}}$.

Mehrere Ausführungsformen der Erfindung sind anhand der folgenden Zeichnungsfiguren näher dargestellt:

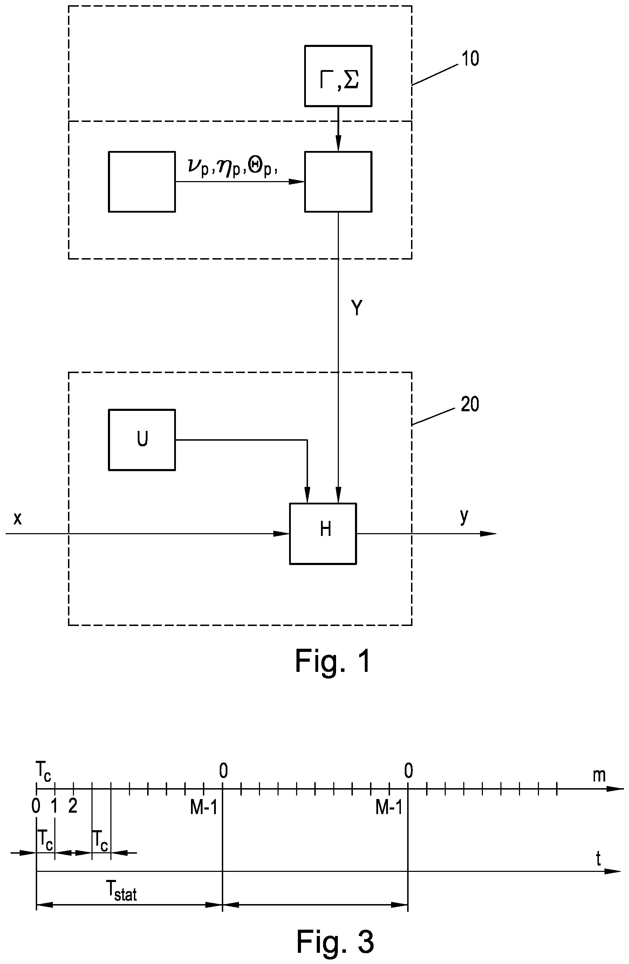

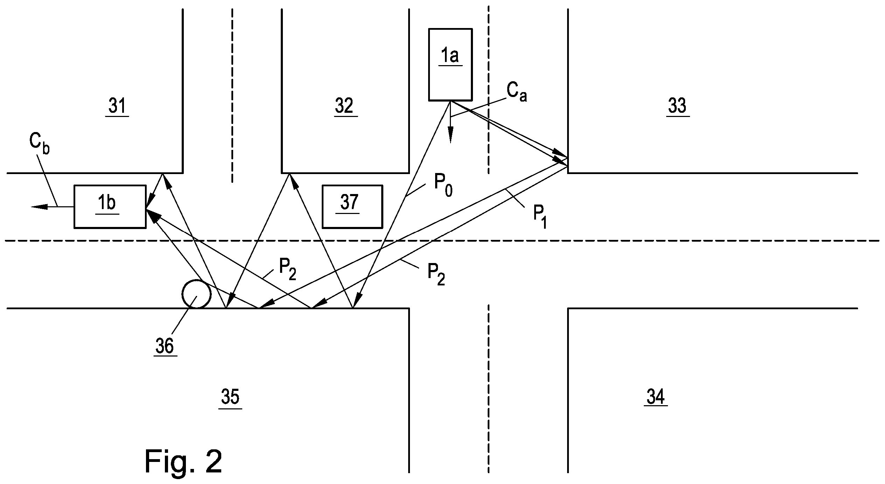

**Fig. 1** zeigt exemplarisch den Aufbau einer Emulationsanordnung zur Durchführung des erfindungsgemäßen Verfahrens. **Fig. 2** zeigt eine exemplarische virtuelle Umgebung, aus der konkret einzelne Ausbreitungspfade ermittelt werden können. **Fig. 3** zeigt schematisch die zeitliche Abfolge

## Erste Ausführungsform

Im Folgenden wird eine erste Ausführungsform der Erfindung im Detail dargestellt.

## Hardware-Setup

Zweck des vorliegenden Verfahrens bzw der in **Fig. 1** dargestellten Anordnung ist die Emulation, dh das Nachahmen, der physikalischen Effekte, die entstehen, wenn eine Funk-Datenübertragung zwischen zwei idR fahrenden Fahrzeugen im Bereich einer Straße erfolgt. Generell besteht aber die Möglichkeit, Kanäle zwischen Sendern und Empfängern, die sich auf beliebigen Vorrichtungen, beispielsweise auch Schiffen, Zügen, Flugzeugen, Satelliten, etc, bewegen oder ihre Position ändern zu emulieren. Darüber hinaus besteht auch in flexiblen Produktionsumgebungen die Notwendigkeit, die Funkkommunikation zwischen bewegten Sendern und Empfängern zu emulieren. Insbesonondere dann, wenn ein Aktuator mit einem Sender oder Empfänger ausgestattet ist, bewegen sich die Sende- und Empfangseinrichtungen mit diesem Aktuator im Raum, sodass sich die Kanaleigenschaften zwischen dem Aktuator und einem Kommunikationspartner ändern. Dabei sind insbesondere Effekte zu berücksichtigen, die sich aus der Bewegung der Fahrzeuge oder Vorrichtungen zueinander ergeben, aber auch Effekte, die durch Objekte oder Hindernisse im Bereich der Fahrbahn entstehen.

Beim vorliegenden Ausführungsbeispiel wird für die Emulation des Übertragungsverhaltens eine Anordnung verwendet, die einerseits einen Simulationsrechner 10 und andererseits einen programmierbaren Schaltkreis 20, insbesondere einen FPGA umfasst. Der Simulationsrechner 10 und der programmierbare Schaltkreis 20 stehen miteinander über eine Datenschnittstelle in Datenverbindung.

Von Bedeutung ist in diesem Zusammenhang, dass über die Datenschnittstelle Daten nicht mit einer beliebigen Bandbreite übertragen werden können, sodass es von großem Vorteil ist, wenn vom Simulationsrechner 10 nur geringe Datenmengen an den programmierbaren Schaltkreis 20 übertragen werden. Darüber hinaus ist auch zu beachten, dass programmierbare Schaltkreise 20 nach Art eines FPGA bestimmte Prozesse parallel und mit großer Geschwindigkeit ausführen können.

Der programmierbare Schaltkreis 20 weist einen analogen Eingang auf, wobei diesem Eingang ein Antennensignal zugeführt ist, das im tatsächlichen Einsatz letztlich an die Sendeantenne angeschlossen wäre. Weiters weist der programmierbare Schaltkreis einen analogen Ausgang auf, wobei an diesem Ausgang ein Antennensignal anliegt, das im tatsächlichen Einsatz letztlich an der Empfangsantenne anliegen würde.

Sofern der programmierbare Schaltkreis keinen analogen Eingang oder Ausgang aufweist, besteht auch die Möglichkeit, das eingehende bzw ausgehende Signal von analog zu digital bzw digital zu analog zu konvertieren.

## Festlegung der virtuellen Umgebung

In einem ersten Schritt wird ausgehend von einem virtuellen Gebiet, dargestellt in **Fig. 2,** das Übertragungsverhalten zwischen zwei im virtuellen Gebiet befindlichen auf Fahrzeugen 1a, 1b angeordneten Antennen näher dargestellt. Dabei werden von einem ersten Fahrzeug 1a, das über eine Sendeantenne verfügt, elektromagnetische Wellen an das Fahrzeug 1b übertragen, das über eine Empfangsantenne verfügt. Im virtuellen Gebiet befinden sich neben den beiden Fahrzeugen 1a, 1b eine Anzahl von Objekten oder Hindernissen 31-37, deren Vorhandensein die Wellenausbreitung zwischen den Antennen auf den Fahrzeugen beeinflusst. Dabei kann es beispielsweise um Gebäude 31-35, im Bereich der Straße befindlichen Installationen 36 oder andere Fahrzeuge 37 handeln. Auch andere Fahrzeuge 37 können sich zeitweise an unterschiedlichen Orten aufhalten und auf das Übertragungsverhalten zwischen der Sendeantenne und der Empfangsantenne Einfluss nehmen. Dieses Verhalten ist im Rahmen der Ermittlung der Ausbreitungspfade $P_0$, $P_1$, $P_2$ einzeln zu berücksichtigen.

Im vorliegenden Fall wird angenommen, dass für die von dem ersten Fahrzeug 1a an das zweite Fahrzeug 1b übermittelten Wellen eine Vielzahl von Ausbreitungspfaden $P_0$, $P_1$, ..., $P_{P-1}$ zur Verfügung stehen, die jeweils unterschiedliche Ausbreitungseigenschaften aufweisen. Bei realistischen Simulationen werden die Ausbreitungspfade $P_0$, $P_1$, ..., $P_{P-1}$ zweidimensional oder dreidimensional charakterisiert, wobei zwischen den beiden Fahrzeugen 1a und 1b je nach erforderlicher Genauigkeit der Simulation ca P=100 bis ca P=5.000 Ausbreitungspfade $P_0$, $P_1$, ..., $P_{P-1}$ ermittelt werden. Je nach erforderlicher Genauigkeit kann die Anzahl der Ausbreitungspfade aber auch größer oder kleiner gewählt werden.

Da die Emulation erfindungsgemäß auch die Änderung des Übertragungskanals in der Zeit berücksichtigt, werden die einzelnen Ausbreitungspfade $P_0$, $P_1$, $P_2$ jeweils zu unterschiedlichen Zeitpunkten neu berechnet. Im vorliegenden Ausführungsbeispiel der Erfindung besteht beispielsweise die Möglichkeit, die Ausbreitungspfade $P_0$, $P_1$, ..., $P_{P-1}$ jeweils für gesamte einzelne Zeitabschnitte zu berechnen. Die Dauer des Zeitabschnitts $T_{stat}$ **(Fig. 3)** kann im vorliegenden Ausführungsbeispiel der Erfindung je nach erwarteter Bewegungsgeschwindigkeit der Fahrzeuge mit zwischen $T_{stat}$ = 1 ms bis $T_{stat}$ = 10 ms festgelegt werden. Die einzelnen Bewegungspfade $C_a$, $C_b$ der Fahrzeuge 1a, 1b sowie die Ausrichtung der Fahrzeuge 1a, 1b werden zu diesem Zweck in Form von stückweise definierten Bewegungspfaden $C_a$, $C_b$ angegeben. Für jedes Fahrzeug 1a, 1b ist somit zu jedem Zeitpunkt bekannt, wo es sich befindet, nach welcher Richtung es sich fortbewegt und mit welcher Geschwindigkeit es sich fortbewegt. Darüber hinaus können aus den für die Fahrzeuge 1a, 1b zur Verfügung stehenden Bewegungspfaden $C_a$, $C_b$ auch andere geometrische Parameter wie Rotationsgeschwindigkeit, Beschleunigungen in Abhängigkeit von der Zeit etc. abgeleitet werden.

Der konkrete Bewegungspfad $C_a$, $C_b$ kann entweder vorab vorgegeben sein oder seinerseits Ergebnis einer Simulation des Fahrverhaltens des Fahrzeugs 1a, 1b sein. So können die Bewegungspfade $C_a$, $C_b$ beispielsweise als Resultate einer Fahrdynamiksimulation einem erfindungsgemäßen Verfahren als Eingangswerte zur Verfügung gestellt werden.

Am Ende dieses Schritts liegt für eine Anzahl von diskreten Zeitpunkten t bzw aufeinanderfolgenden Zeitabschnitten jeweils eine virtuelle Umgebung vor, in der sich jeweils ein erstes Fahrzeug 1a mit einer Sendeantenne und ein zweites Fahrzeug 1b mit einer Empfangsantenne sowie gegebenenfalls weitere Objekte und Hindernisse befinden. Die Fahrzeuge 1a, 1b sowie die Objekte bzw Hindernisse können sich vorzugsweise in der virtuellen Umgebung bewegen.

**Bestimmung der Pfadparameter**

Für jeden einzelnen Ausbreitungspfad $P_0$, $P_1$, ..., $P_{P-1}$ werden separat jeweils der Dämpfungsfaktor $\eta_p$, die Verzögerung $\theta_p$ und die Dopplerfrequenz $v_p$ ermittelt, wobei p zwischen 0 und P-1 liegt und den Index des betreffenden Ausbreitungspfads $P_0$, $P_1$, ..., $P_{P-1}$ angibt. Dieser Ermittlung werden folgende Erwägungen zugrunde gelegt:
Um eine realistische Modellierung der Wellenausbreitung zu ermöglichen, wird ein geometriebasiertes stochastisches Kanalmodell (GSCM) angenommen. Das Kanalmodell wird durch eine nichtstationäre Übertragungsfunktion g(t, f) festgelegt, die zu jedem Zeitpunkt t ein unterschiedliches frequenzabhängiges Übertragungsverhalten aufweist, wobei die Frequenz mit f bezeichnet wird.

$$g(t,f) = g_{\mathrm{Tx}}(f) \underbrace{\left( \sum_{p=0}^{P-1} \eta_p(t)\mathrm{e}^{-\mathrm{j}2\pi\tau_p(t)f} \right)}_{g_{\mathrm{Ph}}(t,f)} g_{\mathrm{Rx}}(f)$$

Das Übertragungsverhalten der verwendeten Sende- und Empfangsfilter kann durch stationäre Übertragungsfunktionen $g_{\mathrm{Tx}}(f)$ und $g_{\mathrm{Rx}}(f)$ dargestellt werden. Die Anwendung dieser Übertragungsfunktionen wird im Folgenden jedoch nicht weiter berücksichtigt.

Die nicht stationäre zeitabhängige Frequenzantwort g(t, f) kann als Überlagerung von Pfadübertragungsfunktionen $g_0(t, f)$, ..., $g_{P-1}(t, f)$ von P individuellen Ausbreitungspfaden $P_0$, $P_1$, ..., $P_{P-1}$ angesehen werden.

Das Übertragungsverhalten elektromagnetischer Wellen auf jedem einzelnen Ausbreitungspfad $P_0$, $P_1$, ..., $P_{P-1}$ kann durch einen komplexen zeitabhängigen Dämpfungskoeffizienten $\eta_p(t)$ beschrieben werden, der wie folgt vorgegeben ist:

$$\eta_p(t) = \beta_p(t)\mathrm{e}^{\mathrm{j}2\pi\phi_p}$$

Dabei stellt $\beta_p(t)$ eine reale Amplitude, $\Phi_p$ eine initiale Phasenverschiebung und $\tau_p(t)$ eine zeitabhängige Verzögerung dar.

Im Zuge der Emulation wird der nicht stationäre zeitvariante Ausbreitungsprozess als stückweise stationär approximiert, wobei der Zeitabschnitt, innerhalb dessen die jeweilige Funktion stationär angesehen wird, mit $T_{\mathrm{stat}}$ bezeichnet wird. Es wird angenommen, dass innerhalb eines solchen Zeitabschnitt $T_{\mathrm{stat}}$ die komplexen Gewichtskoeffizienten $\eta_p(t)$ unverändert sind: $\eta_p(t) \approx \eta_p$. Weiters wird angenommen, dass die Relativgeschwindigkeit zwischen Sende- und Empfangsantennen während eines Zeitabschnitts $T_{\mathrm{stat}}$ konstant sind. Dementsprechend wird die zeitvariante Verzögerung auf dem betreffenden Ausbreitungspfad wie folgt definiert:

$$\tau_p(t) = \tau_p(0) - \frac{f_p}{f}t$$

In diesem Zusammenhang bezeichnet $\tau_p(0)$ die zu Beginn des stationären Intervalls vorliegende Verzögerung, die durch die Distanz zwischen Sende- und Empfangsantenne vorgegeben ist. Dabei bezeichnet $f_p$ die Dopplerfrequenz im Ausbreitungspfad, die wie folgt festgelegt ist:

$$f_p = f_c \frac{v\cos(\alpha_p)}{c_0}$$

Dabei bezeichnet $f_c$ die Trägerfrequenz des Systems, v die Relativgeschwindigkeit zwischen Sende- und Empfangsantenne und $\alpha_p$ den Winkel, mit dem der jeweilige Ausbreitungspfad beim Empfänger ankommt. $c_0$ bezeichnet die Lichtgeschwindigkeit.

In weiterer Folge wird die Kanalübertragungsfunktion $g_{\mathrm{Ph}}(t,f)$ durch eine diskrete Repräsentation ersetzt, wobei eine diskretisierte Übertragungsfunktion g[m,q] vorgegeben wird, die einen diskreten Zeitwert m und einen diskreten Frequenzwert q aufweist. Bei einer Samplingrate $T_C$ **(Fig. 3)** von $T_C = 1/(OSF \cdot B)$ nach der Zeit und einer Diskretisierungsfrequenz $F_s = OSF \cdot B/N$ in der Frequenz ergibt sich

$$g[m, q] := g_{\mathrm{Ph}}(mT_C, qF_s)$$

$$= \sum_{p=0}^{P-1} \eta_p \mathrm{e}^{-\mathrm{j}2\pi\theta_p q} \mathrm{e}^{\mathrm{j}2\pi\nu_p m}$$

Dabei bezeichnet B die Systembandbreite, die kleiner gewählt wird als die Systembandbreite im statischen Fall. M bestimmt die Länge des Stationaritätsbereiches in der Zeit, OSF bezeichnet den Überabtastungsfaktor. Die imaginäre Einheit wird mit j bezeichnet. Weiters wird die normalisierte Dopplerfrequenz $v_p = f_p T_c / OSF$ festgesetzt. Der Wert $\theta_p = \tau_p(0)OSF/(NT_C)$ bezeichnet die normalisierte Verzögerung, wobei $|v_b| < 1/2$ und $0 < \theta_p < 1$.

Zu beachten ist, dass die diskrete Übertragungsfunktion g[m, q] zwar durch die einzelnen stückweise konstanten Pfadparameter $\eta_p$, $v_p$, $\theta_p$ festgelegt ist, diese jedoch im Simulationsrechner nicht in einer Form bestimmt wird, dass sie auf ein vorgegebenes Signal anwendbar wäre.

Zur Charakterisierung des Übertragungsverhaltens zwischen dem Fahrzeug 1a und dem Fahrzeug 1b wird für jeden einzelnen Ausbreitungspfad $P_0$, ..., $P_{P-1}$ jeweils der Dämpfungsfaktor $\eta_p$, die Verzögerung $\theta_p$ und die Dopplerfrequenz $v_p$ festgelegt, diese Parameter bestimmen gemeinsam das Übertragungsverhalten des jeweiligen Ausbreitungspfads $P_0$, ..., $P_{P-1}$. Für jeden Zeitabschnitt wird somit jeweils separat eine Anzahl von Pfadparametern $\eta_p$, $v_p$, $\theta_p$ festgelegt.

**Table-Lookup**

Sind für die einzelnen Ausbreitungspfade $P_0$, ..., $P_{P-1}$ für einen vorgegebenen Zeitabschnitt sämtliche Pfadparameter $\eta_p$, $v_p$, $\theta_p$ bekannt, so kann auf dieser Grundlage eine Übertragungsmatrix $\Psi$ erstellt werden, die das gesamte Übertragungsverhalten aller Ausbreitungspfade $P_0$, ..., $P_{P-1}$ charakterisiert, und aus der sich die Übertragungsfunktion g[m, q] mit linearen Operationen ableiten lässt.

Hierfür wird eine erste Lookup-Table $\Gamma$ vorgegeben, mit der es möglich ist, für jede Dopplerfrequenz $v_p$ einen Koeffizientenvektor, im Folgenden als Dopplervektor $\gamma'_p$ bezeichnet, mit insgesamt $D_t$ Elementen zu erhalten.

$$\gamma'_p = [\gamma'_{0,p}, \gamma'_{1,p}, \ldots, \gamma'_{D_t-1,p}]^T \in \mathbb{C}^{D_t \times 1}$$

Ebenso wird ein zweiter Lookup-Table $\Sigma$ vorgegeben, der es erlaubt, für jede Verzögerung $\theta_p$ einen Koeffizientenvektor, im Folgenden als Verzögerungsvektor $\varepsilon'_p$ bezeichnet, mit insgesamt $D_f$ Elementen zu erhalten:

$$\epsilon'_p = [\epsilon'_{0,p}, \epsilon'_{1,p}, \ldots, \epsilon'_{D_f-1,p}]^T \in \mathbb{C}^{D_f \times 1}$$

Bei einer Variante der Erfindung kann zur Auswertung der Lookup-Tables $\Gamma$, $\Sigma$ vorgesehen sein, dass für eine Anzahl von Intervallen, die gemeinsam den jeweiligen Wertebereich der Pfadparamter $\theta_p$, $v_p$ abdecken, jeweils ein Dopplervektor $\gamma'_p$ oder ein Verzögerungsvektor $\varepsilon'_p$ vorgegeben ist. In einem bevorzugten Ausführungsbeispiel der Erfindung kann der Wertebereich der normierten Dopplerfrequenz $v_p$, die aufgrund der vorstehend genannten Normierung mit [-0,5, +0,5] festgelegt ist, und der Wertebereich der normierten Verzögerung $\theta_p$, die mit [0, 1] festgelegt ist, abhängig von der gewünschten Auflösung bzw Genauigkeit in etwa 1000 den gesamten Wertebereich abdeckende und nicht überlappende Teilbereiche unterteilt werden. In diesem Fall kann für jeden einzelnen gültigen Wert für die Dopplerfrequenz $v_p$ bzw. für die Verzögerung $\theta_p$ jeweils durch Table-Lookup jeweils ein Dopplervektor $\gamma'_p$ bzw Verzögerungsvektor $\varepsilon'_p$ ermittelt werden. Alternativ können auch unterschiedliche Arten der Interpolation verwendet werden, um präzisere Ergebnisse zu erhalten.

Als Ergebnis dieses Table-Lookup stehen nunmehr für jeden einzelnen Ausbreitungspfad $P_0$, ..., $P_{P-1}$ und für jeden Zeitabschnitt jeweils neben den Pfadparametern $\eta_p$, $v_p$, $\theta_p$ ein Dopplervektor $\gamma'_p$ bzw Verzögerungsvektor $\varepsilon'_p$ zur Verfügung.

Im Detail sind Berechnungsvorschriften für die einzelnen Elemente der Lookup-Tables in den folgenden Publikationen näher dargestellt: F. Kaltenberger, "Low Complexity Simulation of Wireless Channels using Discrete Prolate Spheroidal Sequences," Ph.D. dissertation, Technical University Vienna, May 2007; F. Kaltenberger, T. Zemen, and C. W. Ueberhuber, "Low-Complexity Geometry-Based MIMO Channel Simulation," Eurasip Journal on Advances in Signal Processing, vol. 2007, no. 1, p. 095281, 2007, doi: 10.1155/2007/95281.

**Ermittlung der Lookup-Werte**

Im vorhergehenden Schritt wurde der Table-Lookup zur Ermittlung des Dopplervektors $\gamma'_p$ bzw des Verzögerungsvektors $\varepsilon'_p$ beschrieben. Im Folgenden wird eine Möglichkeit dargestellt, die einzelnen Werte der betreffenden Lookup-Tables festzulegen.

Wie bereits erwähnt, soll die zuvor beschriebene zeitvariante Übertragungsfunktion g[m, q] das frequenzabhängige Übertragungsverhalten zu jedem Zeitpunkt innerhalb des betreffenden Zeitabschnitts angeben. Für die folgenden Überlegungen wird davon ausgegangen, dass die zeitvariante Übertragungsfunktion g[m, q] als gewichtete Summe von Produkten von ersten Basisfunktionen $u_0[m]$, ..., $u_{Dt-1}[m]$ nach der diskreten Zeit m mit zweiten Basisfunktionen $v_0[q]$, ..., $v_{Df-1}[q]$ nach der diskreten Frequenz q dargestellt wird. Sowohl die ersten zeitvarianten Basisfunktionen als auch die zweiten frequenzvarianten Basisfunktionen entstammen jeweils einem vorgegebenen diskreten Funktionenraum. Die einzelnen diskreten Werte der ersten und zweiten Basisfunktionen sind komplexe Zahlen. Die einzelnen diskreten Werte der ersten und zweiten Basisfunktionen sind komplexe Zahlen.

Insbesondere kann die Gesamtheit der $D_t$ ersten Basisfunktionen $u_0[m]$, ..., $u_{Dt-1}[m]$ als erste Basismatrix U dargestellt werden, deren Elemente gemäß $\mathbf{U}_{i,m} = u_i[m]$ festgelegt sind. Ebenso kann die Gesamtheit der $D_f$ zweiten Basisfunktionen $v_0[q]$, ... $v_{Df-1}[q]$ als zweite Basismatrix V dargestellt werden, deren Elemente gemäß $\mathbf{V}_{i,q} = v_i[q]$ festgelegt sind.

Bevorzugt werden als erste und zweite Basisfunktionen Slepian-Funktionen verwendet, die auch als "discrete prolate spheroidal sequences" (DPS) bezeichnet werden. Solche Slepian-Funktionen sind beispielsweise aus der Veröffentlichung D. Slepian, "Prolate Spheroidal Wave Functions, Fourier Analysis, and Unvertainty-V: The Discrete Case", Bell System Technical Journal, vol. 57, no. 5, pp. 1371-1430, May 1978, doi: 10.1002/j.1538-7305.1978.tb02104.x. bekannt.

Aufgrund der Modellannahme über die Ausbreitungseigenschaften in den einzelnen Ausbreitungspfaden kann eine Darstellung gefunden werden, bei der der zeitabhängige Teil $g^t_p[m]$ und der frequenzabhängige Teil $g^f_p[q]$ der Pfadübertragungsfunktion sowie die zeit- und frequenzunabhängige Dämpfung als Produkt dargestellt werden

$$g_p[m, q] = \eta_p \mathrm{e}^{-\mathrm{j}2\pi\theta_p q} \mathrm{e}^{\mathrm{j}2\pi\nu_p m} = \eta_p g^f_p[q] g^t_p[m]$$

Die diskreten Werte der Pfadübertragungsfunktion $g_p[m, q]$ können als Pfadübertragungsmatrix $\mathbf{G}_p$ dargestellt werden. Die zeitabhängige diskrete Funktion $g^t_p[m]$ und die frequenzabhängige diskrete Funktion $g^f_p[q]$ können jeweils als Vektoren $\mathbf{g}^t_p$, $\mathbf{g}^f_p$ dargestellt werden, wobei $\mathbf{g}^t_p$ ein Spaltenvektor mit der Länge M ist und $\mathbf{g}^f_p$ ein Spaltenvektor mit der Länge N ist. Die Pfadübertragungsmatrix $\mathbf{G}_p$ kann als Kronecker-Produkt der beiden diskreten Funktionen $g^f_p[q]$, $g^t_p[m]$, multipliziert mit einem konstanten Dämpfungsterm $\eta_p$ wir folgt dargestellt werden:

$$\mathbf{G}_p = \eta_p \mathbf{g}^f_p \mathbf{g}^{tT}_p$$

wobei $\tau$ die transponierte darstellt. Sowohl der zeitabhängige Teil

$$g^t_p[m] = \mathrm{e}^{\mathrm{j}2\pi\nu_p m}$$

als auch der frequenzabhängige Teil

$$g^f_p[q] = \mathrm{e}^{-\mathrm{j}2\pi\theta_p q}$$

können separat durch gewichtete Summen von ersten und zweiten Basisfunktionen

$$u_0[m], \ldots, u_{D_t-1}[m]; v_0[q], \ldots, v_{D_f-1}[q]$$

näherungsweise dargestellt werden. Entsprechend lassen sich auch die Vektoren $\mathbf{g}^t_p$, $\mathbf{g}^f_p$ als gewichtete Summen der Zeilenvektoren der Basismatrizen **U, V** darstellen.

Die einzelnen Elemente des Dopplervektors $\gamma'_p$ und des Verzögerungsvektors $\varepsilon'_p$ geben nun an, wie die einzelnen Zeilenvektoren der Basismatrizen **U, V** jeweils zu gewichten sind, um die betreffenden Vektoren $\mathbf{g}^t_p$, $\mathbf{g}^f_p$ zu erhalten.

Verwendet man die ermittelten Elemente $\gamma'_{0,p}$, ..., $\gamma'_{Dt-1,p}$ des Dopplervektors $\gamma'_p$ zu einem späteren Zeitpunkt als Gewichte für die einzelnen Slepian-Funktionen $S_0[m]$, ... $S_{Dt-1}[m]$, so erhält man bei Durchführung einer gewichteten Summe einen Näherungswert $\underline{g}^t_p[m]$ für den zeitabhängigen Teil $g^t_p[m] = e^{j \cdot 2\pi \cdot vp \cdot m}$ der Modellannahme.

$$g_p^t[m] \sim \underline{g}_p^t[m] = \sum_{i=0}^{D_t-1} \gamma'_{i,p} S_i[m]$$

Die einzelnen Werte der Slepian-Funktionen $S_0[m]$, ..., $S_i[m]$, ... $S_{Dt-1}[m]$ können als Matrix $\mathbf{U}_{i,m}$ aufgefasst und dargestellt werden.

Verwendet man die ermittelten Elemente $\varepsilon'_{0,p}$, ..., $\varepsilon'_{Df-1,p}$ des Verzögerungsvektors $\varepsilon'_p$ zu einem späteren Zeitpunkt als Gewichte für die einzelnen weiteren Slepian-Funktionen $S'_0[q]$, ... $S'_{Df-1}[q]$, so erhält man bei Durchführung einer gewichteten Summe einen Näherungswert $\underline{g}^f_p[q]$ für den frequenzabhängigen Teil $g^f_p[q] = e^{-j \cdot 2\pi \cdot \theta p \cdot q}$ der Modellannahme.

$$g_p^f[q] \sim \underline{g}_p^f[q] = \sum_{i=0}^{D_f-1} \epsilon'_{i,p} S'_i[q]$$

Die einzelnen Werte der weiteren Slepian-Funktionen $S'_0[q]$, ..., $S'_i[q]$, ..., $S'_{Df-1}[q]$ können als Matrix $\mathbf{V}_{i,q}$ aufgefasst und dargestellt werden.

**Bestimmung der Übertragungsmatrix**

Im Folgenden wird die Ermittlung einer Übertragungsmatrix **Y** im Detail dargestellt, wobei für jeden Zeitabschnitt jeweils eine separate Übertragungsmatrix **Y** erstellt wird. Jede Übertragungsmatrix **Y** ist jeweils innerhalb eines diskreten Zeitabschnitts gültig. Besonders vorteilhaft am vorliegenden Vorgehen ist, dass der für die Darstellung und Speicherung der Übertragungsmatrix **Y** erforderliche Speicherplatz unabhängig von der Anzahl P der im Rahmen der Simulation ermittelten Ausbreitungspfade $P_0$, ..., $P_{P-1}$ ist.

In einem ersten Schritt wird für jeden Ausbreitungspfad $P_0$, ..., $P_{P-1}$ einzeln eine Pfadmatrix $\Psi_p$ ermittelt, die dem Kronecker Produkt des Dopplervektors $\gamma'_p$ und des Verzögerungsvektors $\varepsilon'_p$, multipliziert mit dem skalaren Dämpfungskoeffizienten $\eta_p$ entspricht. Die Pfadmatrix $\Psi_p$ hat jeweils $D_f$ Spalten und $D_t$ Zeilen, ihre Einträge sind jeweils komplexe Zahlen. Die Pfadmatrix $\Psi_p$ ist durch die folgenden Vorschrift festgelegt, wobei das Symbol $\otimes$ das Kronecker-Produkt bezeichnet:

$$\boldsymbol{\Psi}_p = \eta_p \cdot \boldsymbol{\gamma}'_p \otimes \boldsymbol{\epsilon}'^T_p$$

Durch Summation der einzelnen Pfadmatrizen $\Psi_p$ erhält man die Summenmatrix $\Psi$, deren Einträge wie folgt festgelegt sind:

$$\boldsymbol{\Psi} = \sum_{p=0}^{P-1} \eta_p \cdot \boldsymbol{\gamma}'_p \otimes \boldsymbol{\epsilon}'^T_p$$

Die Summenmatrix $\Psi$ hat jeweils $D_f$ Spalten und $D_t$ Zeilen, ihre Einträge sind jeweils komplexe Zahlen. Zu beachten ist, dass aufgrund der Summation über die insgesamt P Ausbreitungspfade zwar die Komplexität im Simulationsrechner linear von der Anzahl P der Ausbreitungspfade abhängt, die weitere Verarbeitung jedoch von der Anzahl P der für die Bildung der Summenmatrix $\Psi$ verwendeten Ausbreitungspfade unabhängig ist.

Weiters wird eine Fourier-Transformationsmatrix $\mathbf{W}$ vorgegeben, deren Elemente $[W]_{ij}$ wie folgt festgelegt sind:

$$[\mathbf{W}]_{i,j} = \frac{1}{\sqrt{N}} e^{\frac{-j2\pi(i-1)(j-1)}{N}} \in \mathbb{C}^{N \times N}, \forall i, j \in \{1, \ldots, N\}$$

Anschließend wird eine Matrix $\mathbf{D}$ als Submatrix der Matrix $\mathbf{W}$ vorgegeben, die lediglich die ersten N x L Zeilen bzw Spalten der Fourier-Transformationsmatrix $\mathbf{W}$ aufweist.

Mit dieser Fourier-Transformationsmatrix $\mathbf{D}$ ist es möglich, aufgrund einer diskreten Übertragungsfunktion g[m, q], deren Argumente eine diskrete Zeitvariable m und eine diskrete Frequenzvariable q darstellen, eine rein zeitbasierte Übertragungsfunktion h[m, l] zu ermitteln, wobei m den Zeitpunkt des Signalwerts des Eingangssignals darstellt, dessen Auswirkungen zum Zeitpunkt m+l zu beobachten sind. Betrachtet man die beiden zweidimensionalen diskreten Funktionen h[m, l] und g[m, q] als Matrizen $\mathbf{G}, \mathbf{H}$ der betreffenden Funktionswerte, so besteht der Zusammenhang:

$$H = D^H G.$$

Dabei werden die frequenzabhängigen Vektoren $\mathbf{g}$[m] der Matrix $\mathbf{G}$ in zeitverzögerungsabhängige Vektoren h[m] der Matrix $\mathbf{H}$ transformiert. Geht man weiters davon aus, dass die Matrix $\mathbf{G}$ der Übertragungsfunktion anhand der vorgegebenen Basisfunktionen sowie der Summenmatrix $\Psi$ mit $\mathbf{G} = \mathbf{V} \Psi^T \mathbf{U}^T$ darstellen lässt, so kann die Matrix $\mathbf{H}$ zur Darstellung der rein zeitabhängigen Übertragungsfunktion h[m, l] gemäß

$$\begin{aligned} H \quad &= D^H G \\ &= D^H V \Psi^T U^T \\ &= V' \Psi^T U^T \\ &= Y U^T \end{aligned}$$

festgelegt werden, die Übertragungsmatrix $\mathbf{Y}$ ergibt sich dabei als Produkt $\mathbf{D}^H \mathbf{V} \Psi^T$. Dieses Produkt kann einerseits gebildet werden, indem die Summenmatrix $\Psi$ wie zuvor beschrieben gebildet wird und anschließend mit einer bereits vorberechneten Matrix $\mathbf{V}' = \mathbf{D}^H \mathbf{V}$ multipliziert wird. Die Übertragungsmatrix $\mathbf{Y}$ hat jeweils $D_t$ Spalten und L Zeilen, ihre Einträge sind jeweils komplexe Zahlen.

**Übermittlung der Übertragungsmatrix**

Während die vorstehend genannten Schritte allesamt im Simulationsrechner, dh auf einem PC, Workstation etc ausgeführt wurden, wird der nachfolgend beschriebene Schritt der Ermittlung und Anwendung der Übertragungsfunktion g auf dem programmierbaren Schaltkreis ausgeführt. Für jeden diskreten Zeitabschnitt wird eine Übertragungsmatrix $\mathbf{Y}$ vom Simulationsrechner an den programmierbaren Schaltkreis übertragen und von diesem zwischengespeichert.

**Ermittlung der Übertragungsfunktion**

Wie bereits im Zusammenhang mit der Ermittlung der Einträge der Lookup-Tables erwähnt, wird die Übertragungsfunktion h[m, l] als diskrete zweidimensionale Funktion h[m, l] bzw als Matrix $\mathbf{H}$ dargestellt. Die die Übertragungsfunktion h[m, l] repräsentierende Matrix $\mathbf{H}$ kann, wie bereits erwähnt, als Produkt $\mathbf{H} = \mathbf{Y} \mathbf{U}^T$ der Übertragungsmatrix $\mathbf{Y}$ mit der ersten Basismatrix $\mathbf{U}$ dargestellt werden, die diskret ausgewertete Funktionswerte der Slepian-Funktionen $S_i(m) = \mathbf{U}_{i,m}$ enthält. Die Werte der ersten Basismatrix $\mathbf{U}$ sind im programmierbaren Schaltkreis abgespeichert. Multipliziert man die für jeden Zeitabschnitt neu festgelegte Übertragungsmatrix $\mathbf{Y}$ mit der an sich zeitlich unveränderlichen ersten Basismatrix $\mathbf{U}$, so erhält man die Matrix $\mathbf{H}$ der Übertragungsfunktion. Die Matrix $\mathbf{H}$ hat jeweils M Spalten und L Zeilen, ihre Einträge sind jeweils komplexe Zahlen. Analog kann die Übertragungsfunktion h[m, l] gemäß dem folgenden Zu-

sammenhang ermittelt werden.

$$h[m,l] = \sum_{i=0}^{D_t-1} \Upsilon[l,i]S_i[m]$$

Zu beachten ist, dass die Übertragungsfunktion h[m, l] auf einfache Weise durch Vektoroperationen ermittelt werden kann, die regelmäßig für programmierbare Schaltkreise wie FPGAs zur Verfügung steht.

### Anwendung der Übertragungsfunktion

Im Folgenden wird die Anwendung der Übertragungsfunktion **H** auf das betreffende Eingangssignal x[m] dargestellt. Dabei werden für den betreffenden Zeitabschnitt einer Zeitdauer von $T_{stat}$ jeweils zu M Abtastzeitpunkten Werte am Eingang ermittelt und digitalisiert und zu einem Vektor zusammengefasst, der das Eingangssignal x[m] repräsentiert. Es wird davon ausgegangen, dass das Eingangssignal x[m] in digitaler oder digitalisierter Form vorliegt, wobei m einen diskretisierten Zeitparameter darstellt, der im betreffenden Zeitabschnitt zwischen 0 und M-1 läuft. Auch das zu ermittelnde Ausgangssignal y[m] soll diskret auf denselben M Abtastzeitpunkten innerhalb des Zeitabschnitts $T_{stat}$ festgelegt werden.

Für die konkrete Ermittlung des Ausgangssignals y[m] zu einem diskreten Zeitpunkt m werden lediglich die letzten L Werte des Eingangssignals x[m] verwendet:

$$y[m] = \sum_{i=0}^{L-1} h[m-l,l]x[m-l]$$

Für ein vereinfachtes Beispiel mit L=3 ergibt sich dabei die folgende Vorgehensweise zur Ermittlung des Ausgangssignals:

$$y[0] = x[0]h[0,0]$$
$$y[1] = x[1]h[1,0] + x[0]h[0,1]$$
$$y[2] = x[2]h[2,0] + x[1]h[1,1] + x[0]h[0,2]$$
$$y[3] = x[3]h[3,0] + x[2]h[2,1] + x[1]h[1,2]$$
$$y[4] = x[4]h[4,0] + x[3]h[3,1] + x[2]h[2,2]$$
$$\vdots$$
$$y[M-1] = x[M-1]h[M-1,0] + x[M-2]h[M-2,1] + x[M-3]h[M-3,2]$$
$$y[M] = x[M-1]h[M-1,1] + x[M-2]h[M-2,2]$$
$$y[M+1] = x[M-1]h[M-1,2]$$

Das Ausgangssignal y[m] wird am Ausgang des programmierbaren Schaltkreises zur Verfügung gehalten. Die Werte des Ausgangssignals sind im Allgemeinen komplexe Zahlen. Die komplexen Zahlenwerte werden digital/analog gewandelt und als I und Q Signal einem Modulator zugeführt.

### Zweite Ausführungsform der Erfindung

Bei einer zweiten bevorzugten Ausführungsform der Erfindung wird für jeden einzelnen Ausbreitungspfad neben dem Dämpfungskoeffizienten, der Dopplerfrequenz und der Verzögerung ein zusätzlicher Pfadparameter ermittelt, der die Zunahme oder Abnahme der Dämpfung im betreffenden Ausbreitungspfad über die Zeit angibt. Die Hinzufügung dieses Pfadparameters führt zu einer genaueren Modellierung des betreffenden Ausbreitungspfads.

Geht man davon aus, dass die Dämpfung $\eta_p[m]$ in Abhängigkeit von der Zeit im jeweiligen Intervall gemäß

$\eta_p[m] = a_p + b_p \cdot m$ festgelegt wird, so kann der zeitabhängige Teil der Pfadübertraungsfunktion $g^t_p[m]$ wie folgt dargestellt werden:

$$g_p^t[m] = \eta_p[m]\mathrm{e}^{\mathrm{j}2\pi\nu_p m}$$
$$= a_p\mathrm{e}^{\mathrm{j}2\pi\nu_p m} + b_p m\mathrm{e}^{\mathrm{j}2\pi\nu_p m}$$
$$= a_p c + b_p l$$

Die hierbei entstehende Summe umfasst einen ersten Summanden

$$c = \mathrm{e}^{\mathrm{j}2\pi\nu_p m}$$

dessen Dopplervektor wie bei der ersten Ausführungsform der Erfindung mittels Table-Lookup in dem bereits im Zusammenhang mit der ersten Ausführungsform der Erfindung beschriebenen Lookup-Table $\Gamma$ bezeichnet, ermittelt werden kann.

Die Berechnung des zweiten Summanden

$$l = m\mathrm{e}^{\mathrm{j}2\pi\nu_p m}$$

kann ebenso mittels eines Table-Lookup in einem zweiten Lookup-Table $\Gamma'$ erfolgen. Die Bestimmung der einzelnen Koeffizienten des zweiten Lookup-Table $\Gamma'$ wird dabei analog der Bestimmung der Koeffizienten des ersten Lookup-Table $\Gamma$ vorgenommen und ein weiterer Doppler-Vektor $\gamma''_p$ erhalten.

Alternativ besteht neben der Bestimmung des weiteren Dopplervektors $\gamma''_p$ durch Table-Lookup auch die Möglichkeit, die einzelnen Dopplervektoren mittels der folgenden Vorschrift zu berechnen:

$$\gamma''_p = \mathbf{U}^H\mathrm{diag}(\mathbf{m})\mathbf{U}\gamma'_p$$
$$\mathbf{m} = 0, 1, \ldots, M - 1$$

Die Matrix diag($\mathbf{m}$) bezeichnet dabei eine Diagonalmatrix, in deren Diagonaleneinträgen die Einträge des Vektors $\mathbf{m} = [0,1,...,M-1]$ enthalten sind. Die Matrix $\mathbf{U}$ bezeichnet dabei die Matrix der Basisfunktionen, die Matrix $\mathbf{U}^H$ ist die konjugiert Transponierte der Matrix $\mathbf{U}$.

Um die Berechnung rascher ausführen zu können, kann eine Transformationsmatrix $\mathbf{U}_{tr}$ der folgenden Form vorab berechnet werden.

$$\mathbf{U}_{tr} = \mathbf{U}^H\mathrm{diag}(\mathbf{m})\mathbf{U}$$

Der weitere Dopplervektor kann in diesem Fall wie folgt ermittelt werden.

$$\gamma''_p = \mathbf{U}_{tr}\gamma'_p$$

Die Pfadmatrix $\Psi_p$ kann ausgehend von $\gamma'_p$, $\gamma''_p$ und $\epsilon'_\mathbf{p}$ wie folgt festgelegt werden:

$$\boldsymbol{\Psi}_p = \left(a_p\boldsymbol{\gamma}'_p + b_p\boldsymbol{\gamma}''_p\right) \otimes \boldsymbol{\epsilon}'^T_p$$

Die weitere Vorgehensweise, insbesondere die Bestimmung der Summenmatrix, der Übertragungsmatrix und der Übertragungsfunktion sowie des Ausgangssignals, entspricht der Vorgehensweise der ersten Ausführungsform der Erfindung.

In einer bevorzugten Weiterbildung der Erfindung besteht die Möglichkeit, einzelne Phasensprünge, die durch die unterschiedliche Auswahl der Dopplerfrequenz in den einzelnen Zeitabschnitten entstehen, zu vermeiden. Dabei kann vorgesehen sein, dass die Phasenlage am Ende des betreffenden Zeitabschnitts zu Beginn des jeweils nachfolgenden Zeitabschnitts vorliegt.

Zu diesem Zweck wird für jeden einzelnen Ausbreitungspfad P die Phasenlage am Ende des jeweils vorangehenden Zeitabschnitts ermittelt und am jeweils nachfolgenden Zeitabschnitt als Initialwert gesetzt. Für das S-te Zeitintervall kann die initiale Phasenlage $\Phi_{p,S}$ durch die folgende Vorschrift festgelegt werden, wobei $\Phi_{p,S-1}$ die jeweilige initiale Phasenlage $\Phi_{p,S-1}$ des jeweils vorangehenden Zeitintervalls festgelegt, wobei die durch die Dopplerfrequenz verursachte Phasenverschiebung $v_p \cdot M$ addiert wird:

$$\phi_{p,S} = \phi_{p,S-1} + v_{p,S-1}M$$

In diesem Zusammenhang bezeichnet M die Anzahl der diskreten Zeitpunkte innerhalb des betreffenden Zeitabschnitts. Die initiale Phasenlage wird für jeden Ausbreitungspfad und für jeden Zeitabschnitt separat berechnet und wird bei der Bildung der Pfadmatrizen $\Psi_p$ wie folgt berücksichtigt:

$$\boldsymbol{\Psi}'_p = (a_p \boldsymbol{\gamma}'_p + b_p \boldsymbol{\gamma}''_p) \otimes \boldsymbol{\epsilon}'^{T}_p \, \mathrm{e}^{\mathrm{j}\phi_{p,S}}$$

Eine mögliche Implementierung der Phasenanpassung sieht konkret vor, für jeden einzelnen Ausbreitungspfad jeweils die initiale Phasenverschiebung zu Beginn des aktuellen Zeitabschnitts zwischenzuspeichern und die betreffende initiale Phasenlage nach dem Ende des Zeitabschnitts wie vorstehend beschrieben zu aktualisieren.

**Patentansprüche**

1. Verfahren zur Emulation eines Funkkanals zwischen einem bewegten Sender und einem bewegten Empfänger, die jeweils an zumindest eine Antenne angeschlossen sind, in einem vorgebbaren den Funkkanal beeinflussenden Umfeld,
wobei für eine Anzahl von hintereinander folgenden Zeitabschnitten

   - jeweils die der Emulation zugrunde liegende Relativposition und Relativbewegung und gegebenenfalls relative Ausrichtung und Relativdrehung, der beiden Antennen zueinander vorgegeben wird, wobei die zeitliche Veränderung der Relativposition und Relativbewegung vorab vorgegeben ist, und insbesondere physikalischen Gesetzmäßigkeiten folgt,
   - wobei anhand der Relativposition und Relativbewegung und gegebenenfalls relativen Ausrichtung und Relativdrehung sowie anhand des vorgegebenen Umfelds eine Anzahl von zwischen den Antennen verlaufenden Ausbreitungspfaden ($P_0$, $P_1$, ..., $P_{P-1}$) ermittelt wird, wobei für jeden der Ausbreitungspfade ($P_0$, $P_1$, ..., $P_{P-1}$) separat ein Dämpfungsfaktor ($\eta_p$), eine Verzögerung ($\theta_p$) sowie eine Dopplerfrequenz ($v_p$) ermittelt werden,

   **dadurch gekennzeichnet, dass** ausgehend von den einzelnen Ausbreitungspfaden ($P_0$, $P_1$, ..., $P_{P-1}$) für eine Anzahl hintereinander folgenden Zeitabschnitten jeweils

   - für jeden Ausbreitungspfad ($P_0$, $P_1$, ..., $P_{P-1}$) durch separaten Table-Lookup der Verzögerung und der Dopplerfrequenz, jeweils ein Koeffizientenvektor ($\gamma'_p$, $\epsilon'_p$) erstellt wird und mit diesen Koeffizientenvektoren durch Bildung des Kronecker-Produkts eine Pfadmatrix (**$\Psi_p$**) erstellt wird, und die so erstellten Pfadmatrizen (**$\Psi_p$**) der einzelnen Ausbreitungspfade ($P_0$, $P_1$, ..., $P_{P-1}$) mit der jeweiligen Dämpfung ($\eta_p$) des Ausbreitungspfads ($P_0$, $P_1$, ..., $P_{P-1}$) gewichtet und summiert werden,
   - ausgehend von der so erstellten Summenmatrix ($\Psi$) mittels einer linearen Transformation eine Übertragungsmatrix (**Y**) ermittelt wird, wobei die Transformation diejenige, insbesondere ausschließlich diejenige, Dimension der Übertragungsmatrix (**Y**) gegenüber der Summenmatrix ($\Psi$) reduziert, die dem Koeffizientenvektor ($\epsilon'_p$) der Verzögerung entspricht, und
   - die Übertragungsmatrix (**Y**) an einen programmierbaren Schaltkreis (20) übertragen wird,
   - wobei im programmierbaren Schaltkreis (20) eine Anzahl von diskreten, die Zeitvarianz der Übertragungsfunktionen und/oder der Impulsantwort charakterisierenden Basisfunktionen als Basismatrix (**U**), vorgegeben wird,

- wobei die zeitveränderlichen Impulsantworten des jeweiligen Zeitabschnitts durch Multiplikation der Übertragungsmatrix (Y) mit der Basismatrix (U) ermittelt werden,
- wobei das von dem Sender erzeugte Signal an einem Eingang abgetastet und digitalisiert und derart ein diskretes Eingangssignal (x) erstellt wird,
- wobei das diskrete Eingangssignal (x) mit der zeitveränderlichen Impulsantwort (h) von einem digitalen Schaltkreis gefaltet und derart ein diskretes Ausgangssignal (y) erstellt wird, und
- dass insbesondere ausgehend vom diskreten Ausgangssignal (y) ein zeit- und wertkontinuierliches Ausgangssignal erstellt wird.

2. Verfahren nach Anspruch 1,

- wobei für die einzelnen hintereinander folgenden Zeitabschnitte die Dämpfung für die einzelnen Ausbreitungspfade ($P_0$, $P_1$, ..., $P_{P-1}$) mit linearer Abhängigkeit von der diskreten Zeit vorgegeben wird, wobei als Pfadparameter für die Dämpfung ein konstanter Term ($a_p$) und ein zeitabhängiger Term ($b_p$) vorgegeben werden,
- wobei für jeden Zeitabschnitt und für jeden Ausbreitungspfad ($P_0$, $P_1$, ..., $P_{P-1}$)

  - durch separaten Table-Lookup der Verzögerung ein Verzögerungsvektor ($\varepsilon'_p$) und durch separaten Table-Lookup der Dopplerfrequenz ein Dopplervektor ($\gamma'_p$) erstellt wird,
  - ein aufgrund der Dopplerfrequenz ein weiterer Dopplervektor ($\gamma''_p$) erstellt wird, wobei der weitere Dopplervektor insbesondere erstellt wird:

    -- durch Table-Lookup in einem weiteren Lookup-Table, oder
    -- durch Ermittlung aufgrund der folgenden Vorschrift,

$$\gamma''_p = \mathbf{U}^H \mathrm{diag}(\mathbf{m}) \mathbf{U} \gamma'_p$$

  wobei die Matrix diag(m) eine Diagonalmatrix bezeichnet, in deren Diagonaleneinträgen die Einträge des Vektors $\mathbf{m} = [0, 1, ..., M-1]$ enthalten sind, die Matrix $\mathbf{U}$ die Matrix der Basisfunktionen und die Matrix $\mathbf{U}^H$ die konjugiert Transponierte der Matrix $\mathbf{U}$ bezeichnet,

  - das Kronecker-Produkt des Verzögerungsvektors ($\varepsilon'_p$) und des Dopplervektors gebildet und mit dem konstanten Term der Dämpfung gewichtet wird und,
  - das Kronecker-Prdoukt des Verzögerungsvektors ($\varepsilon'_p$) und des weiteren Dopplervektor gebildet und mit dem zeitabhängigen Term der Dämpfung geichtet wird, und
  - die Pfadmatrix ($\Psi_p$) als Summe dieser Kronecker-Produkte errechnet wird.

3. Verfahren nach Anspruch 1 oder 2, **dadurch gekennzeichnet,**

- **dass** für die einzelnen Zeitabschnitte für jeden einzelnen Ausbreitungspfad ($P_0$, ..., $P_{P-1}$) jeweils eine zu Beginn des aktuellen Zeitabschnitts vorliegende initiale Phasenverschiebung ($\Phi_{p,S-1}$) zur Verfügung gehalten wird und jeweils nach dem Ende des Zeitabschnitts eine initiale Phasenverschiebung ($\Phi_{p,S}$) für den nachfolgenden Zeitabschnitt gemäß

$$\phi_{p,S} = \phi_{p,S-1} + v_{p,S-1} M$$

ermittelt wird,
wobei $v_{p,S-1}$ die Dopplerfrequenz im jeweils vorangehenden Zeitabschnitt bezeichnet und M die Länge der Zeitabschnitte festlegt, und
- **dass** bei der Bestimmung der Pfadmatrix ($\Psi_p$) für die einzelnen Ausbreitungspfade ($P_0$, $P_1$, ..., $P_{P-1}$) eine Phasenkorrektur entsprechend der jeweiligen initialen Phasenverschiebung ($\Phi_{p,S}$) vorgenommen wird, insbesondere durch Gewichtung oder Multiplikation mit $e^{j\,\Phi_{p,S}}$.

**Claims**

1. Method for emulating a radio channel between a moved transmitter and a moved receiver, which are in each case connected to at least one antenna, in a predetermined environment influencing the radio channel, wherein for a number of time segments following one after another

   - in each case the relative position upon which the emulation is based and relative movement and where appropriate relative orientation and relative rotation of the two antennae to one another is predetermined, wherein the temporal change in the relative position and relative movement is predetermined in advance, and in particular follows the laws of physics,
   - wherein on the basis of the relative position and relative movement and where appropriate relative orientation and relative rotation as well as on the basis of the predetermined environment a number of paths of propagation ($P_0$, $P_1$, ..., $P_{P-1}$) extending between the antennae is determined, wherein for each of the paths of propagation ($P_0$, $P_1$, ..., $P_{P-1}$) a damping factor ($\eta_p$), a delay ($\theta_p$) and a Doppler frequency ($v_p$) are determined separately,

   **characterised in that** starting from the individual paths of propagation ($P_0$, $P_1$, ..., $P_{P-1}$) for a number of time segments following one after another in each case

   - for each path of propagation ($P_0$, $P_1$, ..., $P_{P-1}$) by means of separate table-lookup of the delay and the Doppler frequency, in each case one coefficient vector ($\gamma'_p$, $\varepsilon'_p$) is created and with these coefficient vectors by forming the Kronecker product a path matrix ($\Psi_p$) is created, and the thus created path matrices ($\Psi_p$) of the individual paths of propagation ($P_0$, $P_1$, ..., $P_{P-1}$) are weighted and summed with the respective damping ($\eta_p$) of the path of propagation ($P_0$, $P_1$, ..., $P_{P-1}$),
   - starting from the thus created sum matrix ($\Psi$) a transmission matrix **(Y)** is determined, wherein the transformation reduces that, in particular exclusively that, dimension of the transmission matrix **(Y)** with respect to the sum matrix ($\Psi$) which corresponds to the coefficient vector ($\varepsilon'_p$) of the delay, and
   - the transmission matrix **(Y)** is transmitted to a programmable switching circuit (20),
   - wherein in the programmable switching circuit (20) is predetermined a number of discrete basis functions as a basis matrix **(U)**, which basis functions characterise the time variance of the transmission functions and/or the impulse response,
   - wherein the time-varying impulse responses of the respective time segment are determined by multiplying the transmission matrix **(Y)** with the basis matrix **(U)**,
   - wherein the signal generated by the sender is sampled at an input and digitalised and thus a discrete input signal **(x)** is generated,
   - wherein the discrete input signal **(x)** is convoluted by a digital switching circuit with the time-varying impulse response and thus a discrete output signal ($\gamma$) is generated, and
   - that in particular starting from the discrete output signal ($\gamma$) a time- and value-continuous output signal is generated.

2. Method according to claim 1,

   - wherein for the individual time segments following one after another the damping for the individual paths of propagation ($P_0$, $P_1$, ..., $P_{P-1}$) is predetermined with linear dependency on the discrete time, wherein as path parameters for the damping a constant term ($a_p$) and a time-dependent term ($b_p$) are predetermined,
   - wherein for each time segment and for each path of propagation ($P_0$, $P_1$, ..., $P_{P-1}$)

     - by means of separate table lookup of the delay a delay vector ($\varepsilon'_p$) is generated and by means of separate table lookup of the Doppler frequency a Doppler vector ($\gamma'_p$) is generated,
     - an on the basis of the Doppler frequency a further Doppler vector ($\gamma''_p$) is generated, wherein the further Doppler vector is in particular generated:

       - by means of table lookup in a further lookup table, or
       - by determining on the basis of the following rule,

$$\boldsymbol{\gamma}''_p = \mathbf{U}^H \mathrm{diag}(\mathbf{m}) \mathbf{U} \boldsymbol{\gamma}'_p$$

     wherein the matrix diag(**m**) denotes a diagonal matrix, in the diagonal entries of which are contained the entries of the vector **m** = [0.1, ..., M-1], the matrix **U** describes the matrix of the basis functions and the matrix **U**$^H$ describes the conjugated transpose of the matrix **U,**

- the Kronecker product of the delay vector ($\varepsilon'_p$) and of the Doppler vector is formed and weighted with the constant term of the damping and,
- the Kronecker product of the delay vector ($\varepsilon'_p$) and of the further Doppler vector is formed and weighted with the time-dependent term of the damping, and
- the path matrix ($\Psi_{\mathbf{p}}$) is calculated as the sum of these Kronecker products.

3. Method according to claim 1 or 2, **characterised in,**

- **that** for the individual time segments for each individual path of propagation (P$_0$, ..., P$_{P-1}$) in each case one initial phase shift ($\Phi_{p,S-1}$) present at the beginning of the current time segment is kept ready and in each case after the end of the time segment an initial phase shift ($\Phi_{p,S}$) for the following time segment according to

$$\phi_{p,S} = \phi_{p,S-1} + v_{p,S-1}M$$

is determined,
wherein $v_{p,S-1}$ describes the Doppler frequency in the respectively preceding time segment and M determines the length of the time segments, and
- **that** in the determination of the path matrix ($\Psi_p$) for the individual paths of propagation (P$_0$, P$_1$, ..., P$_{P-1}$) a phase correction is undertaken corresponding to the respective initial phase shift ($\Phi_{p,S}$), in particular by weighting or multiplying with e$^{j\,\phi p,S}$.

**Revendications**

1. Procédé d'émulation d'un canal radio entre un émetteur mobile et un récepteur mobile, qui sont chacun reliés à au moins une antenne, dans un environnement prédéterminable qui influence le canal radio,
dans lequel, pendant un certain nombre de périodes consécutives

- respectivement la position relative et le mouvement relatif et, le cas échéant, l'alignement relatif et la rotation relative des deux antennes l'une à l'autre, sur lesquels l'émulation est basée, sont prédéterminés, dans lequel le changement de position relative et de mouvement relatif dans le temps est prédéterminé, et en particulier suit des lois physiques,
- dans lequel un certain nombre de trajets de propagation (P$_0$, P$_1$, ..., P$_{P-1}$) entre les antennes est déterminé sur la base de la position relative et du mouvement relatif et, le cas échéant, de l'alignement relatif et de la rotation relative, et sur la base de l'environnement prédéterminé, dans lequel un facteur d'atténuation ($\eta_p$), un retard ($\theta_p$) et une fréquence Doppler ($v_p$) sont déterminés séparément pour chacun des trajets de propagation (P$_0$, P$_1$, ..., P$_{P-1}$),

**caractérisé en ce que,** sur la base des trajets de propagation individuels (P$_0$, P$_1$, ..., P$_{P-1}$) pour un certain nombre de périodes consécutives, respectivement

- pour chaque trajet de propagation (P$_0$, P$_1$, ..., P$_{P-1}$), un vecteur de coefficient ($\gamma'_p$, $\varepsilon'_p$) est respectivement créé par une consultation de table séparée du retard et de la fréquence Doppler, et une matrice de trajet ($\Psi_{\mathbf{p}}$) est créée avec ces vecteurs de coefficient en formant le produit de Kronecker, et les matrices de trajet ($\Psi_{\mathbf{p}}$) des trajets de propagation individuels (P$_0$, P$_1$, ..., P$_{P-1}$) ainsi créées sont pondérées et additionnées avec l'atténuation respective ($\eta_p$) du trajet de propagation (P$_0$, P$_1$, ..., P$_{P-1}$),
- sur la base de la matrice somme ($\Psi$) ainsi créée, une matrice de transfert **(Y)** est déterminée au moyen d'une transformation linéaire, dans lequel la transformation réduit la dimension de la matrice de transfert **(Y),** en particulier exclusivement celle-ci, par rapport à la matrice somme ($\Psi$), qui correspond au vecteur de coefficient ($\varepsilon'_p$) du retard, et
- la matrice de transfert **(Y)** est transférée à un circuit programmable (20),
- dans lequel, dans le circuit programmable (20), un certain nombre de fonctions de base discrètes caractérisant la variance temporelle des fonctions de transfert et/ou la réponse impulsionnelle est prédéterminé sous la forme d'une matrice de base **(U),**

- dans lequel les réponses impulsionnelles variables dans le temps de la période respective sont déterminées en multipliant la matrice de transfert **(Y)** par la matrice de base **(U),**
- dans lequel le signal généré par l'émetteur est détecté et numérisé à une entrée, créant ainsi un signal d'entrée discret **(x),**
- dans lequel le signal d'entrée discret **(x)** est convoluté avec la réponse impulsionnelle variable dans le temps **(h)** par un circuit numérique, produisant ainsi un signal de sortie discret **(y),** et
- **en ce qu'**un signal de sortie continu dans le temps et en valeur est généré, en particulier sur la base du signal de sortie discret **(y)**.

2.  Procédé selon la revendication 1,

- dans lequel l'atténuation pour les trajets de propagation individuels ($P_0$, $P_1$, ..., $P_{P-1}$) avec une dépendance linéaire du temps discret est spécifiée pour les périodes consécutives individuelles, dans lequel un terme constant ($a_p$) et un terme temporel ($b_p$) sont spécifiés comme paramètres de trajet pour l'atténuation,
- dans lequel, pour chaque période et pour chaque trajet de propagation ($P_0$, $P_1$, ..., $P_{P-1}$)
- un vecteur de retard ($\varepsilon'_p$) est créé par une consultation de table séparée du retard et un vecteur Doppler ($\gamma'_p$) est créé par une consultation de table séparée de la fréquence Doppler,
- un un vecteur Doppler supplémentaire ($\gamma''_p$) est créé sur la base de la fréquence Doppler, dans lequel le vecteur Doppler supplémentaire est en particulier créé :

-- par une consultation de table dans une consultation de table supplémentaire, ou
-- par une détermination sur la base de la prescription suivante,

$$\gamma''_p = \mathbf{U}^H \mathrm{diag}(\mathbf{m}) \mathbf{U} \gamma'_p$$

dans lequel la matrice diag(**m**) désigne une matrice diagonale dont les entrées diagonales contiennent les entrées du vecteur **m** = [0,1,...,M-1], la matrice **U** désigne la matrice des fonctions de base et la matrice **U**$^H$ désigne la transposée conjuguée de la matrice **U,**

- le produit de Kronecker du vecteur de retard ($\varepsilon'_p$) et du vecteur Doppler est formé et pondéré avec le terme constant de l'atténuation et,
- le produit de Kronecker du vecteur de retard ($\varepsilon'_p$) et du vecteur Doppler supplémentaire est formé et pondéré avec le terme temporel de l'atténuation, et
- la matrice de trajet ($\Psi_p$) est calculée comme la somme de ces produits de Kronecker.

3.  Procédé selon la revendication 1 ou 2, **caractérisé**

- **en ce qu'**un déphasage initial ($\Phi_{p,S-1}$) présent au début de la période en cours respective est maintenu à disposition pour les périodes individuelles de chaque trajet de propagation individuel ($P_0$, ..., $P_{P-1}$) et un déphasage initial ($\Phi_{p,S}$) est déterminé pour la période consécutive respective après la fin de la période, selon

$$\dot{\phi}_{p,S} = \dot{\phi}_{p,S-1} + v_{p,S-1}M$$

dans lequel $v_{p,S-1}$ désigne la fréquence Doppler dans la période précédente respective et M détermine la longueur des périodes, et
- **en ce que**, lors de la détermination de la matrice de trajet ($\Psi_p$) pour les trajets de propagation individuels ($P_0$, $P_1$, ..., $P_{P-1}$), une correction de phase est réalisée en fonction du déphasage initial respectif ($\Phi_{p,S}$), en particulier par pondération ou multiplication avec e$^{j\,\Phi p,S}$.

Fig. 1

Fig. 3

Fig. 2

EP 3 539 230 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

• EP 1578032 A1

**In der Beschreibung aufgeführte Nicht-Patentliteratur**

• **GHIAASI GOLSA et al.** Real-time vehicular channel emulator for future conformance tests of wireless ITS modems. *2016 10TH EUROPEAN CONFERENCE ON ANTENNAS AND PROPAGATION (EUCAP), EUROPEAN ASSOCIATION OF ANTENNAS AND PROPAGATION,* 10. April 2016, 1-5
• Low Complexity Simulation of Wireless Channels using Discrete Prolate Spheroidal Sequences. **F. KALTENBERGER.** Ph.D. dissertation. Technical University Vienna, Mai 2007

• **F. KALTENBERGER ; T. ZEMEN ; C. W. UEBER-HUBER.** Low-Complexity Geometry-Based MIMO Channel Simulation. *Eurasip Journal on Advances in Signal Processing,* 2007, vol. 2007 (1), 095281
• **D. SLEPIAN.** Prolate Spheroidal Wave Functions, Fourier Analysis, and Unvertainty-V: The Discrete Case. *Bell System Technical Journal,* Mai 1978, vol. 57 (5), 1371-1430